# EUROPEAN PATENT APPLICATION

(11) **EP 2 472 602 A2**
(43) Date of publication of application: **04.07.2012**
(21) Application number: 11195788.2
(22) Date of filing: 27.12.2011
(51) Int. Cl.: H01L 33/00, H01L 33/40, H01L 33/64, H01L 33/38

(54) **Vertical light emitting diode (VLED) die and method of fabrication**

(30) Priority: 03.01.2011 US 983436
(71) Applicant: Semileds Optoelectronics Co., Ltd., Miao-Li County (TW)
(72) Inventor: Chu, Jiunn-Yi, Hsinchu County 302 (TW); Chu, Chen-Fu, Hsingchu City 300 (TW); Cheng, Chao-Chen, Hsinchu City 300 (TW)
(74) Representative: Ergün, Mevci

(57) **Abstract**

A vertical light emitting diode "VLED" die (10) includes a first metal (12) having a first surface and an opposing second surface: a second metal (14) on the second surface of the first metal (12); a p-type semiconductor layer (16) on the first surface of the first metal (12); a multiple quantum well "MQW" layer (18) on the p-type semiconductor layer (16) configured to emit light: and an n-type semiconductor layer (20) on the multiple quantum well "MQW" layer (18).

## Description

### Background

This disclosure relates generally to optoelectronic components and more particularly to a vertical light emitting diode (VLED) die, and method of fabrication.

An optoelectronic system, such as a light emitting diode (LED), can include one o0r more light emitting diode (LED) dice mounted to a substrate. One type of light emitting diode (LED) die, known as a vertical light emitting diode (VLED) die, includes a multi-layer semiconductor substrate made of a compound semiconductor material, such as GaN. The semiconductor substrate can include a p-type confinement layer having p-type dopants, an n-type confinement layer having n-type dopants, and a multiple quantum well (MQW) layer located between the confinement layers configured to emit light.

The present disclosure is directed to a vertical light emitting diode (VLED) die and to a method for fabricating the vertical light emitting diode (VLED) die. The vertical light emitting diode (VLED) can be used to construct light emitting diodes (LED) having improved thermal and electrical characteristics.

### Summary

A vertical light emitting diode (VLED) die includes a first metal having a first surface and an opposing second surface, a second metal on the second surface of the first metal, and an epitaxial stack on the first metal. The first metal and the second metal form a stepped structure for protecting the epitaxial stack. The epitaxial stack includes a first type semiconductor layer on the first surface of the first metal, a multiple quantum well (MQW) layer on the first type semiconductor layer configured to emit light; and a second type semiconductor layer on the multiple quantum well (MQW) layer. In an illustrative embodiment, the first type semiconductor layer comprises a p-type layer, such as p-GaN, and the second type semiconductor layer comprises an n-type layer, such as n-GaN.

A method for fabricating the vertical light emitting diode (VLED) die includes the steps of: providing a carrier substrate, forming an epitaxial stack on the carrier substrate, forming a plurality of first trenches in a criss-cross pattern through the epitaxial stack and the carrier substrate to define a plurality of dice on the carrier substrate, forming a reflector layer on the epitaxial stack, forming a seed layer on the reflector layer and in the trenches, forming a first metal on the seed layer having a first area, forming a second metal on the first metal having a second area less than the first area, removing the carrier substrate, forming a plurality of second trenches through the epitaxial stack to the seed layer, and separating the dice into a plurality of separate vertical light emitting diode (VLED) dice.

### Brief Description of the Drawings

Exemplary embodiments are illustrated in the referenced figures of the drawings. It is intended that the embodiments and the figures disclosed herein are to be considered illustrative rather than limiting.

Figure 1A is a schematic cross sectional view of a vertical light emitting diode (VLED) die;

Figure 1B is a schematic plan view of the vertical light emitting diode (VLED) die;

Figure 1C is a schematic bottom view of the vertical light emitting diode (VLED) die;

Figure 2 is a schematic cross sectional view of a light emitting diode system incorporating the vertical light emitting diode (VLED) die; and

Figures 3A-3K are schematic cross sectional views illustrating steps in a method for fabricating the vertical light emitting diode (VLED) die.

### Detailed Description

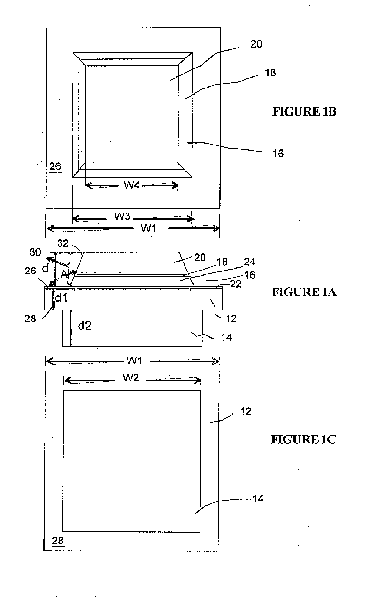

Referring to Figures 1A-1C, a vertical light emitting diode (VLED) die 10 (Figure 1A) includes a first metal 12; a second metal 14; a p-type semiconductor layer 16 on the first metal 12; a multiple quantum well (MQW) layer 18 on the p-type semiconductor layer 16; and an n-type semiconductor layer 20 on the multiple quantum well (MQW) layer 18. The vertical light emitting diode die (VLED) 10 also includes a seed layer 22 (Figure 1A) on the first metal 12 and a reflector layer 24 (Figure 1A) on the seed layer 22.

A preferred material for the p-type semiconductor layer 16 comprises p-GaN. Other suitable materials for the p-type layer include AlGaN, InGaN and AlInGaN. A preferred material for the n-type semiconductor layer 20 comprises p-GaN. Other suitable materials for the n-type layer include AlGaN, InGaN and AlInGaN. The multiple quantum well (MQW) layer 18 can comprise a semiconductor material, such as GaAs, sandwiched between two layers of a semiconductor material, such as AlAs having a wider bandgap.

The first metal 12 (Figure 1A) includes a first surface 26 (Figure 1A) and an opposing second surface 28 (Figure 1A). The reflector layer 24 (Figure 1A) is formed on the first surface 26 (Figure 1A), and the second metal 14 (Figure 1A) is formed on the second surface 28 (Figure 1A). As shown in Figure 1B, the first metal 12 (Figure 1A) has a generally square peripheral outline with four equal sides. Alternately, the first metal 12 (Figure 1A) can have any suitable polygonal peripheral outline (e.g., rectangular, triangular), or a circular outline. In addition, the first metal 12 (Figure 1A) has a thickness (d1) (Figure 1A) and a width (W1) (Figure 1B) on each side. A representative range for the thickness (d1) of the first metal 12 can be from 1 µm to 500 µm. A representative range for the width (W1) of the first metal 12 can be from 1 µm to 10000 µm. In the case of a circular outline, the width (W1) would be equivalent to the diameter (D) of the circle. A representative value for the area of the first metal 12 (Figure 1A) can be from 1 µm² to 10⁸ µm².

The first metal 12 (Figure 1A) can comprise a single metal layer or a stack of two or more metal layers, formed using a suitable deposition process. In addition, the material for the first metal 12 is selected to provide a high electrical conductivity and a high thermal conductivity. Suitable materials for the first metal 12 include Cu, Ni, Ag, Au, Co, Cu-Co, Ni-Co, Cu-Mo, Ni/Cu, Ni/Cu-Mo and alloys of these metals. Suitable deposition processes for forming the first metal 12 include electro-deposition, electroless-deposition, chemical vapor deposition (CVD), plasma enhanced chemical vapor deposition (PECVD), physical vapor deposition (RVD), evaporation, and plasma spray.

The second metal 14 (Figure 1A) has a generally square peripheral outline with four equal sides centered symmetrically on the first metal 12. Alternately, the second metal 14 (Figure 1A) can have any suitable peripheral outline (e.g., rectangular, triangular) and can be offset on the first metal. As another alternative the second metal 14 (Figure 1A), and the first metal 12 (Figure 1A) as well, can have a circular peripheral outline, and a concentric alignment. In addition, the second metal 14 (Figure 1A) has a thickness (d2) (Figure 1A) and a width (W2) (Figure 1B) on each side. A representative range for the thickness (d2) can be from 1µm to 500 µm. A representative range for the width (W2) can be from 0.5 µm to 9999 µm. The maximum width (W2) and area of the second metal 14 (Figure 1A) are dependant on the geometry but are less than the maximum width (W1) and area of the first metal 12 (Figure 1A). Stated differently, the maximum width (W1) and area of the first metal 12 (Figure 1A) are greater than the maximum width (W2) and area of the second metal 14 (Figure 1A). As such, the first metal 12 (Figure 1A) and the second metal 14 (Figure 1A) form a stepped protective structure. In the claims to follow, the area of the first metal 12 is referred to as the "first area", and the area of the second metal 14 is referred to as the "second area".

The second metal 14 (Figure 1A) can comprise a single metal layer, or a stack of two or more metal layers formed using a suitable deposition process. In addition, the material for the second metal 14 is selected to provide a high electrical conductivity and a high thermal conductivity. Suitable materials for the second metal 14 include Cu, Ni, Ag, Au, Co, Cu-Co, Ni-Co, Cu-Mo, Ni/Cu, Ni/Cu-Mo and alloys of these metals. Suitable deposition processes for the second metal 14 include electro-deposition, electroless-deposition, chemical vapor deposition (CVD), plasma enhanced chemical vapor deposition (PECVD), physical vapor deposition (PVD), evaporation, and plasma spray.

The seed layer 22 (Figure 1A) can comprise a blanket deposited metal layer formed using a suitable deposition process, such as electro-deposition or electroless deposition. As will be further explained, the seed layer 22 is configured to assist the formation of the first metal 12 and the second metal 14 using a suitable deposition process, such as electroplating or electroless plating. In addition, the seed layer 22 can comprise a single metal layer or a metal stack. Suitable materials for the seed layer 22 include Ta/Cu. Ta/TaN/Cu/ TaN/Cu. Ti/TaN/Cu/ Ta/TiN/Cu. Ti/Cu. Ti/Tn/Cu/ TiN/Cu. Cr/Au. Cr/Au/Ni/Au. Cr/Au/Ti/Ni/Au. Ti/Au and Ti/Ni/Au. The reflector layer 24 can also comprise a single metal layer or a metal stack. Suitable materials for the reflector layer 24 include Ag/Ti/Au. Ag/TiN/Cu. Ag/Ta/Au. Ag/W/Au. Ag/TaN/Cu. Ag/Ni/Au. Al/Ta/Au. Al/TaN/Cu. Ni/Ag, Ni/Al and Ni/Ag/Ni/Au.

The p-type semiconductor layer 16 (Figure 1A), the multiple quantum well (MQW) layer 18 (Figure 1A) and the n-type semiconductor layer 20 (Figure 1A) form an epitaxial stack 30 (Figure 1A) having a thickness (d) on the seed layer 22. In the epitaxial stack 30. the p-type semiconductor layer 16 (Figure 1A) and the n-type semiconductor layer 20 (Figure 1A) function as confinement layers, and the multiple quantum well (MQW) layer 18 (Figure 1A) functions as a light emitting layer.

The epitaxial stack 30 (Figure 1A) can be formed on the reflector layer 24 using a suitable deposition process, such as vapor phase epitaxy (VPE) molecutar beam epitaxy (MBE) or liquid phase epitaxy (LPE). A representative range for the thickness (d) of the epitaxial stack 30 can be from I µm to 50 µm. In addition, the epitaxial stack 30 (Figure 1A) has four sloped side walls 32 (Figure 1A) formed at an angle (A) from the surface of the seed layer 22 (Figure 1A), where the surface of the seed layer 22 (Figure 1A) is parallel to the first surface 26 (Figure 1A) of the first metal 12 (Figure 1A). The angle (A) is greater than 90 degrees, with a representative range for the angle (A) being from 100 degrees to 145 degrees. In addition, the epitaxial stack 30 (Figure 1A) is generally pyramidal in shape with a flat top (rather than pointed as with a true pyramid). Further, the reflector layer 24 can have an area and a maximum width that are less than an area and maximum width of the p-type semiconductor layer 16.

The epitaxial stack 30 (Figure 1A) has a four-sided base portion formed by the p-type semiconductor layer 16 with a width (W3), and a four-sided tip portion formed by the n-type semiconductor layer 20 with a width (W4). The maximum width (W4) of the n-type semiconductor layer 20 is less than the maximum width (W3) of the p-type semiconductor layer 16. In addition, the area of the tip portion of the epitaxial stack 30 (Figure 1A) formed by the top surface of the n-type layer, is less than the area of the base portion of the epitaxial stack 30 (Figure 1A) formed by the bottom surface p-type semiconductor layer 16 (Figure 1A). Stated differently, the cross sectional area of the epitaxial stack 30 (Figure 1A) decreases from the base portion to the tip portion. Rather than being generally pyramidal in shape, the epitaxial stack 30 (Figure 1A) can be generally conical in shape with a circular base and flat circular tip potion. As another alternative, the epitaxial stack 30 (Figure 1A) can have an elongated rectangular base portion, and an elongated pyramidal shape.

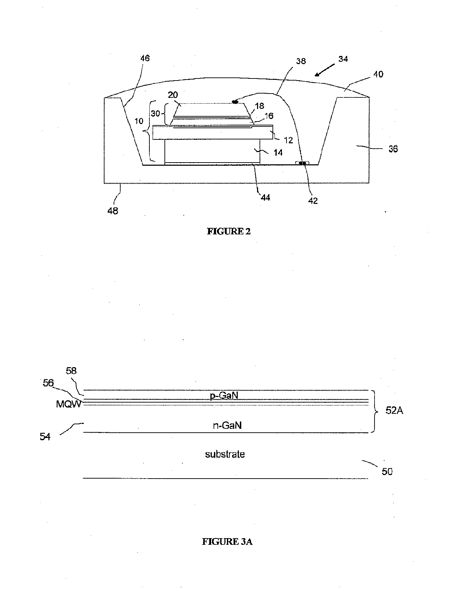

Referring to Figure 2, a light emitting diode (LED) 34 includes n substrate 36, the vertical light emitting diode (VLED) die 10 mounted to the substrate 36. and an electrically insulating, light transmissive passivation layer 40 which encapsulates the light emitting diode (VLED) die 10, For illustrative purposes in Figure 2. the light emitting diode (LED) 34 is shown with only one vertical light emitting diode (VLED) die 10 mounted to the substrate 36. However, in actual practice the light emitting diode (LED) 34 can include a plurality of vertical light emitting diode (VLED) dice 10 mounted to the substrate 36. and arranged in a desired array to form an optoelectronic device, such as an LED display. The substrate 36 can comprise a semiconductor material, such as silicon (Si), or another material, such GaAs, SiC, AlN, Al₂O₃, or sapphire. The substrate 36 includes a cavity 46 wherein the vertical light emitting diode (VLED) die 10 is mounted, and a back side 48. An electrically conductive die attach layer (not shown) can be used to attach the vertical light emitting diode (VLED) die 10 to the substrate 36.

As shown in Figure 2, a wire bonded wire 38 electrically connects the n-type semiconductor layer 20 to an n-electrode 42 on the substrate 36. In addition, the first metal 12 and the second metal 14 electrically connect the p-type semiconductor layer 16 to a p-electrode 44 on the substrate 36. The first metal 12 and the second metal 14 also provide a heat transfer path from the vertical light emitting diode (VLED) die 10 to the substrate 36. This heat transfer path is enhanced by the stepped structure provided by the first mental 12 and the second metal 14. In addition, the larger first metal 12 provides a protective structure or "overhang" that prevents a die attach material, such as Ag paste or solder, from overflowing and contacting the epitaxial stack 30.

Referring to Figures 3A-3K, steps in a method for fabricating the vertical light emitting diode (VLED) die 10 are illustrated. Initially, as shown in Figure 3A, a carrier substrate 50 is provided. The carrier substrate 50 can be in the form of a wafer comprised of a suitable material, such as sapphire, silicon carbide (SiC), silicon, germanium, zinc oxide (ZnO), or gallium arsenide (GaAs). In the examples to follow the carrier substrate 50 comprises sapphire.

As also shown in Figure 3A, a multi layer epitaxial structure 52A is formed on the carrier substrate 50 using a suitable deposition process such as vapor phase epitaxy (VPE) molecular beam epitaxy (MBE) or liquid phase epitaxy (LPE). The multi layer epitaxial structure 52A includes an n-type layer 54. one or more quantum well layers 56. and a p-type layer 58. In the illustrative embodiment, the n-type layer 54 comprises n-GaN and the p-type layer 58 comprises p-GaN. Rather than GaN. the n-type layer 54 and the p-type layer 58 can comprise various other compound semiconductor materials,. such as AlGaN, InGaN, and AllnGaN. The quantum well layers 56 can be formed of suitable materials such as a GaAs layer sandwiched between two layers of a material with a wider bandgap such as AlAs.

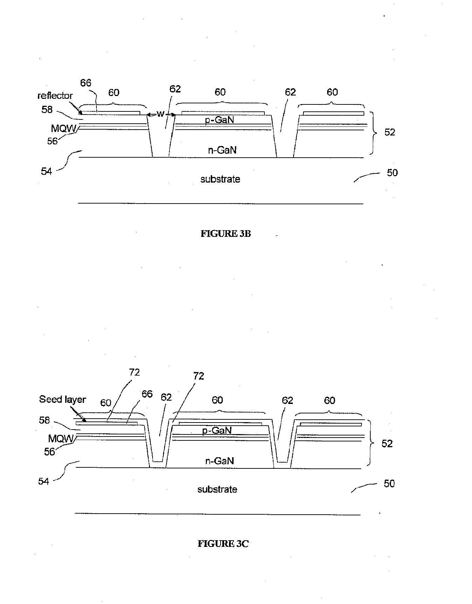

Next as shown in Figure 3B. a suitable process can be used to form trenches 62 through the epitaxial structure 52A (Figure 3A) that can endpoint on the substrate 50 as shown, or alternately that can extend a short distance into the substrate 50, The trenches 62 can be formed in a criss-cross pattern similar to the streets between dice in a conventional semiconductor fabrication process, such that a plurality of defined dice 60. and separate epitaxial stacks 52, are formed. A suitable process for forming the trenches 62 comprises dry etching through a hard mask. Other suitable processes include laser cutting, saw cutting, diamond cutting, wet etching, and water jetting. After the trench forming process, the dice 60 may be cleaned in a liquid or a solvent to remove the etch mask, or other protective coating. A width (w) of the trenches 62 can be in a range of from about 0.1 µm to about 300 µm.

As also shown in Figure 3B. a suitable process can be used to form a reflector layer 66 on the p-type layer 58. that functions as a reflector or mirror for photons in the vertical light emitting diode (VLED) die 10. By way of example, the reflector layer 66 can comprise multiple layers, such as Ni/Ag/Ni/Au. Au/Ni/Au. Ti/Ag/Ni/Au, Ag/Pt or Ag/Pd or Ag/Cr, formed by depositing an alloy containing Ag, Au.Cr, Pt, Pd, or Al. A thickness of the reflector layer 66 (mirror) can be less than about 1.0 µm. High temperature annealing or alloying of the reflector layer 66 can be used to improve the contact resistance and adhesion or the reflector layer 66 to the p-type layer 58- For example, the annealing or alloying process can be conducted at a temperature of at least 150°C in an inert environment (*e.g..* an atmosphere containing tittle or no oxygen, hydrogen, or neither oxygen nor hydrogen).

Next, as shown in Figure 3C. a seed layer 72 can be formed on the reflector layer 66 and on the sidewalls of the trenches 62 using an electroplating or an electroless plating process. The seed layer 72 can comprise a single layer or a stack, such as Ta/Cu, Ta/TaN/Cu, TaN/Cu, Ti/TaN/Cu, Ta/TiN/Cu, Ti/Cu, Ti/Tn/Cu, TiN/Cu, Ti/Cu, Ti/Tn/Cu, TiN/Cu, Cr/Au, Cr/Au/Ni/Au, Cr/Au/Ti/Ni/Au, Ti/Au, Ti/Ni/Au, Ni/Au or Ni/Cu, The reflector layer 66 can also be formed as a blanket layer that may also act as a seed layer. In this case, the reflector layer 66 can comprise a single layer, or stacked layers, such as Ag/Ti/Au, Ag/TiN/Cu, Ag/Ta/Au, Ag/W/Au, Ag/TaN/Cu, Al/Ta/Au, Al/TaN/Cu, Ni/Ag. Ni/Al or Ni/Ag/Ni/Au.

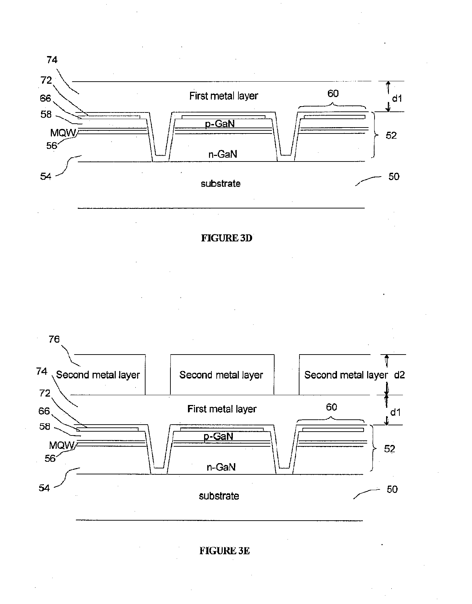

Next, as shown in Figures 3D and 3E, a first metal layer 74 is deposited on the seed layer 72 to a thickness of d1. and a second metal tayer 76 is deposited on the first metal layer 74 to a thickness of d2. The first metal layer 74 will form the first metal 12 (Figure 1A), and the second metal layer 76 will form the second metal 14 (Figure 1A) vertical light emitting diode (VLED) die 10 (Figure 1A). The first metal layer 74 can be formed using a suitable deposition process, such as an electro-deposition process or an electroless deposition process, to a desired thickness d1. A representative range for the thickness d1 of the first metal layer 74 can be from 1 µm to 500 µm. Similarly, the second metal layer 76 can be formed using a suitable deposition process, such as an electro-deposition process or an electroless deposition process, to a desired thickness d2. A representative range for the thickness d2 of the second metal layer 76 can be from 1 µm to 500 µm. The first metal layer 74 and the second metal layer 76 can comprise a single layer of a metal such as Cu. Ni, Ag, Au or Co. a metal alloy such is Cu-Co or Cu-Mo, or a metal stack such as Ni/Cu or Ni/Cu-lvlo. Other suitable deposition processes for the first metal layer 74 and the second metal layer 76 include chemical vapor deposition (CVD), plasma enhanced chemical vapor deposition (PECVD), physical vapor deposition (PVD), evaporation, and plasma spray.

As also shown in Figure 3E, the second metal layer 76 can be patterned using a suitable process such as etching an initially deposited layer (e.g.. subtractive process), or alternately patterned deposition through a mask (e.g.. additive process), to define the shape of the second metal 14. The second metal layer 76 is patterned such that all urea and a width W2 (Figure 1C) of the second metal 14 (Figure 1A) is less than an area and a width W) (Figure 1C) of the first metal 12 (Figure 1A). In addition, one or more additional metal layers such as Cr/Au, Ni or Ni/Au (nor shown) can be formed on the second metal layer 76 and on exposed surfaces of the first metal layer 74 for oxidation and corrosion protection.

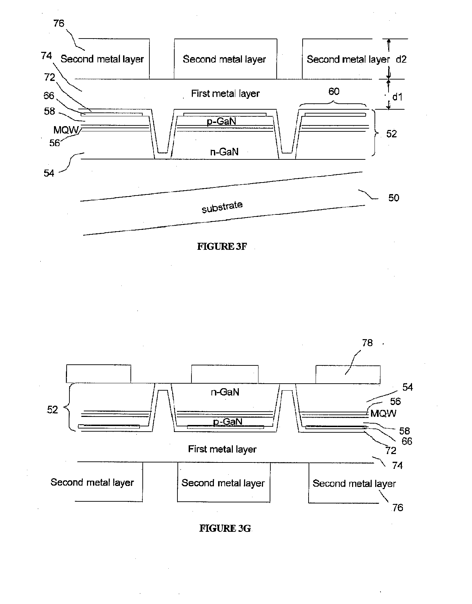

Next, as shown in Figure 3F, the carrier substrate 50 can be removed from the n-type layer 54 using a suitable process such as a pulse laser irradiation process, etching, or chemical mechanical planarization (CMP).

Next, as shown in Figure 3G, a hard mask 78 can be formed on the surface of the n-type layer 54 from which the carrier substrate 50 has been removed. The hard mask 78 can comprise a grown or deposited material such as SiO2 or Si₃N₄ Alternately, the hard mask 78 can comprise an organic polymer material, such as an epoxy, a polyimide, a thermoplastic or a sot-gel. A photo sensitive organic material, such as SU-8-NR-7. AZ5214E can also be employed. As another alternative, the hard mask 78 can comprise an inorganic material such as SiO_{2,} ZnO, Ta₂O₅, TiO_{2,} HTO, or MgO.

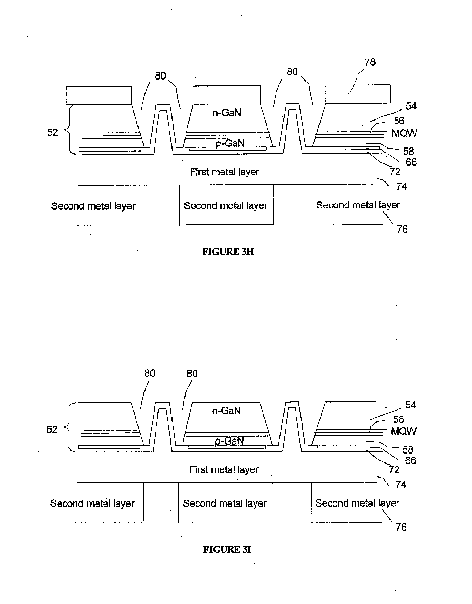

Next, as shown in Figure 3H. the hard mask 78 can be used to etch trenches 80 through the epitaxial stack 52 to the seed layer 72. Etching can comprise dry etching (ICP RIE), wet chemical etching or photo-enhanced chemical etching. As also shown in Figure the size of the trenches 80 in a region proximate to a surface of the n-type layer 54 can be larger than in a region proximate to the surface of the p-type layer 58. Stated differently, the trenches 80 decrease in size as the depth increases. The slope of the trenches 80 plus 90 degrees forms the angle A of the epitaxial stack 30 (Figure 1A) in the completed vertical sight emitting diodes (VLED) 10 (Figure 1A).

Next, as shown in Figure 3I. the hard mask 78 can be removed using a suitable solvent or using a suitable wet ctr dry etching process.

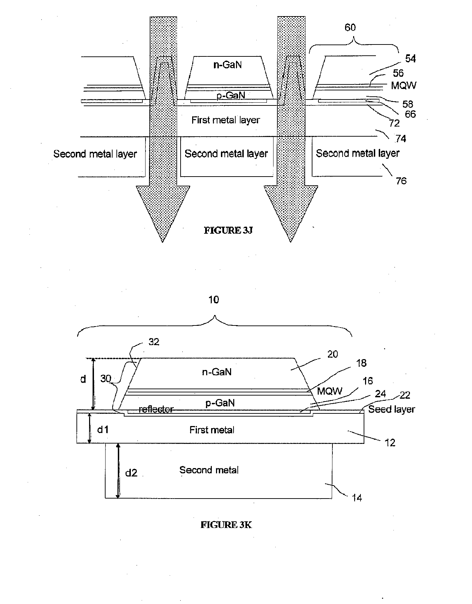

Next, as shown in Figure 3J, a separating (or dicing) process can be performed to separate the dice 60 into separate vertical light emitting diodes (VLHD) 10 (Figure 1A). The separating process can be performed using a suitable process such as laser dicing, sawing, breaking, air knifing or water jetting. In addition, one or more antioxidation layers (not shown) can be applied to selected surfaces such as edges, using a suitable process, such as plating using a water jet solution.

As shown in Figure 3K, each vertical light emitting diode (VLED) 10 includes a first metal 12 formed by a portion of the first metal layer 74 (Figure 3I): a second metal 14 formed by a portion of the second metal layer 76 (Figure 3J): a p-type semiconductor layer 16 formed by a portion of the p-type layer 58 (Figure 3J): a multiple quantum well (MQW) layer 18 formed by a portion of the multiple quantum well (MQW) layer 56 (Figure 3J): and an n-type semiconductor layer 20 formed by a portion of the n-type layer 54 (Figure 3J). Each vertical light emitting diode die (VLED) 10 also includes a seed layer 22 formed by a portion of the seed layer 72 (Figures 3J) and a reflector layer 24 formed by a portion of the reflector laser 66 (Figure 3J).

Thus the disclosure describes an improved vertical light emitting diode (VLED) die and method of fabrication. White a number of exemplary aspects and embodiments have been discussed above, those of skill in the art will recognize certain modifications, permutations, additions and subcombinations thereof. It is therefore intended that the following appended claims and claims hereafter introduced are interpreted to include all such modifications, permutations, additions and subcombinations as are within their true spirit and scope.

## Claims

1. A vertical light emitting diode (VLED) die comprising:
a first metal having a first surface, an opposing second surface and art first area:
a second metal on the second surface of the first metal having a second area, with the first area of the first metal greater than the second area of the second metal forming a stepped structure:
an epitaxial stack on the first metal comprising:
a first type semiconductor layer on the first surface of the First metal:
a multiple quantum well (MQW) layer on the first type semiconductor layer configured to emit light: and
a second type semiconductor layer on the multiple quantum well (MQW) layer.

2. The vertical light emitting diode (VLED) die of claim 1 wherein the first type semiconductor layer comprises a p-type semiconductor layer and the second type semiconductor layer comprises an n-type semiconductor layer.

3. The vertical light emitting diode (VLED) die of claim 1 further comprising a reflector layer on the first surface of the first metal

4. The vertical light emitting diode (VLED) die of claim 1 wherein the epitaxial stack is generally pyramidal in shape with the first type semiconductor layer forming a base portion and the second type semiconductor layer forming a tip portion.

5. The vertical light emitting diode (VLED) die of claim 1 wherein the first metal comprises a material selected from the group consisting of Cu. Ni. Ag, Au, Co, Cu-Co, Ni-Co, Cu-Mo, Ni/Cu, Ni/Cu-Mo and alloys of these metals.

6. The vertical light emitting diode (VLED) die of claim 1 wherein the second metal comprises a material selected from the group consisting of Cu, Ni, Ag, Au, Co, Cu-Co, Ni-Co, Cu-Mo, Ni/Cu, Ni/Cu-Mo and alloys of these metals.

7. The vertical light emitting diode (VLED) die of claim 1 wherein the first type semiconductor layer comprises a p-type semiconductor layer comprising a material selected from the group consisting of GaN. AlGaN, InGaN and AlInGaN.

8. The vertical light emitting diode (VLED) die or claim 1 wherein the second type semiconductor layer comprises an n-type semiconductor layer comprising a material selected from the group consisting of GaN, AlGaN. InGaN and AlInGaN.

9. The vertical light emitting diode (VLED) die of claim 1 wherein the first type semiconductor layer comprises p-GaN and the second type semiconductor layer comprises n-GaN.

10. A vertical light emitting diode (VLED) die comprising:
a first metal having a first surface, an opposing second surface and a first area:
a second metal on the second surface of the first metal having a second area, with the first area of the first metal greater than the second area of the second metal:
an epitaxial stack on the first surface of the first metal comprising:
a p-type semiconductor layer on the first surface of the first metal:
a multiple quantum well (MQW) layer on the p-type semiconductor layer configured to emit light; and
an n-type semiconductor layer on the multiple quantum well (MQW) layer,
the first metal and the second metal forming a stepped protective structure for protecting the epitaxial stack,
the epitaxial stack having sloped sidewalls with an angle between the sidewalls and the first metal greater than 90°.

11. The vertical light emitting diode (VLED) die of claim 10 further comprising a reflector layer on the first surface of the first metal.

12. The vertical light emitting diode (VLED) die of claim 10 wherein the epitaxial stack is generally pyramidal in shape with the p-type semiconductor layer forming a base portion and the n-type semiconductor layer forming a tip portion.

13. The vertical light emitting diode (VLED) die or claim 10 wherein the first metal and the second metal comprise a material selected from the group consisting of Cu, Ni, Ag, Au, Co, Cu-Co, Ni-Co, Cu-Mo, Ni/Cu, Ni(Cu-Mo and alloys of these metals.

14. The vertical light emitting diode (VLED) die of claim 10 wherein the p-type semiconductor layer and the n-lype semiconductor tayer comprise a material selected from the group consisting or GaN. AlGaN. InGaN and AlInGaN.

15. The vertical light emitting diode (VLED) die of claim 10 wherein an area and a maximum width of the n-type semiconductor layer are less than an area and a maximum width of the p-type semiconductor layer,

16. A method for fabricating a vertical light emitting diode (vLED) die comprising:
providing a carrier substrate;
forming an epitaxial stack on the carrier substrate:
forming a plurality of first trenches in a criss cross pattern through the epitaxial stack and the carrier substrate to define a plurality of dice on the carrier substrate:
forming a seed layer on the epitaxial stack and in the trenches:
forming a reflector layer on the seed layer:
forming a first metal on the seed layer having a first area:
forming a second metal on the first metal having a second area less than the first area;
removing the carrier substrate:
forming a plurality of second trenches through the epitaxial stack to the seed layer; and
separating the dice into a plurality of separate vertical light emitting diode (VLED) dice.

17. The method of claim 16 wherein each epitaxial stack comprises a p-type semiconductor layer on the first surface of the first metal: a multiple quantum well (MQW) layer on the p-typc semiconductor layer configured to emit light: and an n-type semiconductor layer on the multiple quantum well (MQW) layer.

18. The method of claim 16 wherein an angle between sidewalls of the epitaxial stack and the first metal are greater than 90°.

19. The method of claim 16 wherein the first metal and the second metal comprise a material selected from the group consisting of Cu, Ni, Ag, Au, Co, Cu-Co, Ni-Co, Cu-Mo, Ni/Cu, Ni/Cu-Mo and alloys of these metals.

20. The method of claim 16 wherein the forming the second trenches step comprises etching through a mask.
